# EUROPEAN PATENT APPLICATION

(11) **EP 4 783 240 A1**
(43) Date of publication of application: **29.07.2026**
(21) Application number: 24883872.4
(22) Date of filing: 21.05.2024
(51) Int. Cl.: H01L 23/538, H01L 21/56, H01L 21/50, H01L 23/498

(54) **DIE PACKAGING STRUCTURE AND ELECTRONIC DEVICE**

(30) Priority: 03.11.2023 CN 202311469345
(71) Applicant: HUAWEI TECHNOLOGIES CO., LTD., Shenzhen 518129 (CN)
(72) Inventor: ZHAO, Nan, Shenzhen, Guangdong 518129 (CN); HU, Tianqi, Shenzhen, Guangdong 518129 (CN); HUANG, Chao, Shenzhen, Guangdong 518129 (CN); ZHAO, Ning, Shenzhen, Guangdong 518129 (CN); HAN, Chao, Shenzhen, Guangdong 518129 (CN); JIANG, Yu, Shenzhen, Guangdong 518129 (CN); CHEN, Shuhui, Shenzhen, Guangdong 518129 (CN)
(74) Representative: Isarpatent
(86) International application number: PCT/CN2024/094391
(87) International publication number: WO 2025/091859

(57) **Abstract**

This application provides a chip package structure and an electronic device, and relates to the field of chip technologies, to meet a requirement of high bandwidth density between chips while supporting heterogeneous chip (die) integration. The chip package structure includes a first chip, an electronic element, and a hybrid interposer of a new structure. The hybrid interposer includes a silicon interposer and a redistribution layer, a front surface of the silicon interposer is provided with a metal routing layer, and a through silicon via is disposed inside the silicon interposer. The first chip is disposed on the front surface of the silicon interposer, and is electrically connected to the metal routing layer. Alternatively, the hybrid interposer includes a first redistribution layer, a second redistribution layer, and a bridge die and a metal connection structure that are located between the two redistribution layers. The bridge die implements interconnection between first chips through the first redistribution layer. The second redistribution layer is connected to the first redistribution layer through the metal connection structure. The electronic element is located on a back surface of the redistribution layer, and is connected to the redistribution layer or is connected to the redistribution layer through a substrate.

## Description

This application claims priority to Chinese Patent Application No. 202311469345.7, filed with the China National Intellectual Property Administration on November 3, 2023 and entitled "CHIP PACKAGE STRUCTURE AND ELECTRONIC DEVICE", which is incorporated herein by reference in its entirety.

### TECHNICAL FIELD

This application relates to the field of chip technologies, and in particular, to a chip package structure and an electronic device.

### BACKGROUND

A system in package (system in package, SiP) technology is an integrated circuit packaging technology in which a plurality of dies (dies) and passive devices are integrated into a single package body. In the post-Moore era, the system in package (SiP) technology can help improve integration, reduce sizes, and reduce power consumption of finished chips.

In the conventional technology, a system in package structure is provided, where a largest complete continuous square is cut from a wafer (wafer) as a chip, and an area may reach 46,225 mm². This structure has a low yield rate due to the large wafer area, cannot support selection and re-integration of a KGD (known good die, known good die) on the wafer, and cannot support heterogeneous chip integration. In addition, a large chip area needs to be used together with a large-sized substrate to implement power supply and signal transmission. Consequently, a stress risk, a power supply implementation, and a heat dissipation implementation of an entire system become complex.

To support KGD selection and heterogeneous chip integration, another system in package structure is further provided in the conventional technology, to implement interconnection between a plurality of dies on a redistribution layer (redistribution layer, RDL) through re-construction (re-construction). However, in this package structure, because the plurality of dies are interconnected through the RDL, bandwidth density between the dies is constrained and cannot be very high, the bandwidth density can reach only about 0.8 Tbps/mm, and high-density interconnection with a higher bandwidth cannot be supported. Consequently, a requirement scenario of high bandwidth density between the dies cannot be met.

### SUMMARY

This application provides a chip package structure and an electronic device, to meet a requirement of high bandwidth density between chips while supporting heterogeneous chip (die) integration.

This application provides a chip package structure. The chip package structure includes a silicon interposer (Si interposer), at least one first chip, at least one electronic element, and a redistribution layer. A front surface of the silicon interposer is provided with a metal routing layer, and a through silicon via TSV (through silicon via) is disposed inside the silicon interposer. The redistribution layer is located on a back surface of the silicon interposer and is electrically connected to the TSV. The first chip is located on the front surface of the silicon interposer, and is electrically connected to the metal routing layer on the front surface of the silicon interposer. The electronic element is located on a side that is of the redistribution layer and that is away from the first chip, and is electrically connected to the redistribution layer or is connected to the redistribution layer through a substrate.

In the chip package structure, the metal routing layer on the front surface of the silicon interposer may be processed by using a silicon-based process, so that a trace width, a trace spacing, and a trace thickness of a metal trace in the metal routing layer can meet an interconnection requirement of high bandwidth density between a plurality of chips (first chips), for example, interconnection bandwidth density greater than 2 Tbps/mm. The redistribution layer on the back surface of the silicon interposer may use a thick metal layer and a thick dielectric layer that have a better current equalization capability, to meet a requirement of the electronic element for driving a high-speed serdes (serializer/deserializer, serializer/deserializer) with a large current equalization capability, low impedance, and a long spacing.

In some possible implementations, a trace width, a trace spacing, and a trace thickness of a metal trace in the metal trace layer that is located on a side on which an active surface is located in the silicon interposer are all less than 5 µm; and a trace width, a trace spacing, and a trace thickness of a metal trace in the redistribution layer are all greater than 5 µm.

In a possible implementation, the at least one first chip may include one or more of a central processing unit, a graphics processing unit, a memory, an input/output chip, an integrated passive device, and a packaged functional assembly.

In a possible implementation, the at least one electronic element includes one or more of a power supply module, a control module, a connector, a clock device, a rectifier, and a resistor-capacitor-inductor.

In some possible implementations, the chip package structure includes a plurality of first chips and a plurality of electronic elements.

In some possible implementations, the plurality of electronic elements include a plurality of power supply modules, and the plurality of power supply modules are respectively disposed opposite to the plurality of first chips. Through the redistribution layer and the silicon interposer, the power supply module is electrically connected to the oppositely disposed first chip, and supplies power to the first chip.

In some possible implementations, the chip package structure includes a plurality of discrete substrates. The substrate is located between the redistribution layer and the electronic element, and the plurality of electronic elements are electrically connected to the redistribution layer through the plurality of discrete substrates. In this way, types of the plurality of substrates can be flexibly selected based on an electrical requirement of the electronic element, to improve performance of an entire system. In addition, using the plurality of discrete substrates can further alleviate mechanical stress caused by thermal mismatch in an assembly and service scenario caused by one large continuous substrate, and is friendlier to system assembly and service reliability.

In some possible implementations, the plurality of substrates are molded in a molding layer, to protect the plurality of substrates through the molding layer.

In some possible implementations, the chip package structure further includes a first heat dissipation panel and a second heat dissipation panel. The first heat dissipation panel is disposed on a side that is of the first chip and that is away from the silicon interposer, and the second heat dissipation panel is disposed on a side that is of the electronic element and that is away from the redistribution layer. The first heat dissipation panel and the second heat dissipation panel are disposed to meet heat dissipation of the chip package structure.

In some possible implementations, the chip package structure further includes a fastening structure. The fastening structure penetrates and fastens the first heat dissipation panel, the second heat dissipation panel, and a hybrid interposer. The hybrid interposer includes the silicon interposer and the redistribution layer.

This application further provides a chip package structure. The chip package structure includes at least one first chip, at least one electronic element, a first redistribution layer, a second redistribution layer, at least one bridge die, and a metal connection structure. The bridge die and the metal connection structure are connected between the first redistribution layer and the second redistribution layer, and the first redistribution layer is located on an active surface of the bridge die. The first chip is located on a side that is of the first redistribution layer and that is away from the bridge die, and the first chip is electrically connected to the bridge die through the first redistribution layer. The electronic element is located on a side that is of the second redistribution layer and that is away from the first redistribution layer, and is connected to the second redistribution layer or is connected to the second redistribution layer through a substrate.

In the chip package structure, because the bridge die may be made by using a silicon-based process, a trace width, a trace spacing, and a trace thickness of a metal trace on a surface of the bridge die can meet an interconnection requirement of high bandwidth density between chips. On this basis, the first redistribution layer may use a thin metal layer and a thin dielectric layer, and the active surface of the bridge die may be directly led out in a region of the bridge die through the first redistribution layer, to implement the interconnection requirement of high bandwidth density between the chips (first chips). The second redistribution layer on the back surface of the bridge die may use a thick metal layer and a thick dielectric layer that have a better current equalization capability, to meet a requirement of the electronic element for driving a high-speed serdes with a large current equalization capability, low impedance, and a long spacing.

For example, in some possible implementations, a trace width, a trace spacing, and a trace thickness of a metal trace in the first redistribution layer are all less than 5 µm, and a trace width, a trace spacing, and a trace thickness of a metal trace in the second redistribution layer are all greater than 5 µm.

In some possible implementations, the metal connection structure includes a metal post, and the bridge die and the metal post are molded in a molding layer.

In some possible implementations, a glass wafer is disposed between the first redistribution layer and the second redistribution layer, a trench is disposed in the glass wafer, the bridge die is embedded in the trench, and the metal connection structure includes a through glass via TGV (through glass via) that penetrates the glass wafer.

In a possible implementation, the at least one first chip may include one or more of a central processing unit, a graphics processing unit, a memory, an input/output chip, an integrated passive device, and a packaged functional assembly.

In a possible implementation, the at least one electronic element includes one or more of a power supply module, a control module, a connector, a clock device, a rectifier, and a resistor-capacitor-inductor.

In some possible implementations, the chip package structure includes a plurality of first chips and a plurality of electronic elements.

In some possible implementations, the chip package structure may include the bridge die, the bridge die is located between two adjacent first chips, and the bridge die connects the two adjacent first chips through the first redistribution layer.

In some possible implementations, the plurality of electronic elements include a plurality of power supply modules, and the plurality of power supply modules are respectively disposed opposite to the plurality of first chips. Through the redistribution layer and the bridge die, the power supply module is electrically connected to the oppositely disposed first chip, and supplies power to the first chip.

In some possible implementations, the chip package structure includes a plurality of discrete substrates. The substrate is located between the second redistribution layer and the electronic element, and the plurality of electronic elements are electrically connected to the second redistribution layer separately through the plurality of discrete substrates. In this way, types of the plurality of substrates can be flexibly selected based on an electrical requirement of the electronic element, to improve performance of an entire system. In addition, using the plurality of discrete substrates can further alleviate mechanical stress caused by thermal mismatch in an assembly and service scenario caused by one large continuous substrate, and is friendlier to system assembly and service reliability.

In some possible implementations, the plurality of substrates are molded in an epoxy molding compound, to protect the plurality of substrates through the molding layer.

In some possible implementations, the chip package structure further includes a first heat dissipation panel and a second heat dissipation panel. The first heat dissipation panel is disposed on a side that is of the first chip and that is away from the first redistribution layer, and the second heat dissipation panel is disposed on a side that is of the electronic element and that is away from the second redistribution layer. The first heat dissipation panel and the second heat dissipation panel are disposed to meet heat dissipation of the chip package structure.

In some possible implementations, the chip package structure further includes a fastening structure. The fastening structure penetrates and fastens the first heat dissipation panel, the second heat dissipation panel, and a hybrid interposer. The hybrid interposer includes the first redistribution layer, the second redistribution layer, and an interposer (including the bridge die and the metal connection structure) connected between the first redistribution layer and the second redistribution layer.

This application further provides an electronic device. The electronic device includes a circuit board and the chip package structure according to any one of the foregoing possible implementations. The chip package structure is electrically connected to the circuit board.

### BRIEF DESCRIPTION OF DRAWINGS

FIG. 1 is a diagram of a chip package structure according to an embodiment of this application;
FIG. 2 is a diagram of a chip package structure according to Embodiment 1 of this application;
FIG. 3 is a diagram of a chip package structure according to Embodiment 1 of this application;
FIG. 4A to FIG. 4C are a diagram of a chip package structure in a production process according to Embodiment 1 of this application;
FIG. 5A and FIG. 5B are a diagram of a chip package structure in a production process according to Embodiment 1 of this application;
FIG. 6 is a diagram of a chip package structure in a production process according to Embodiment 1 of this application;
FIG. 7 is a diagram of a chip package structure in a production process according to Embodiment 1 of this application;
FIG. 8 is a diagram of a chip package structure in a production process according to Embodiment 1 of this application;
FIG. 9 is a diagram of a chip package structure according to Embodiment 2 of this application;
FIG. 10A to FIG. 10C are a diagram of a chip package structure in a production process according to Embodiment 2 of this application;
FIG. 11 is a diagram of a chip package structure in a production process according to Embodiment 2 of this application;
FIG. 12A and FIG. 12B are a diagram of a chip package structure in a production process according to Embodiment 2 of this application;
FIG. 13A and FIG. 13B are a diagram of a chip package structure in a production process according to Embodiment 2 of this application;
FIG. 14 is a diagram of a chip package structure in a production process according to Embodiment 2 of this application;
FIG. 15A and FIG. 15B are a diagram of a chip package structure in a production process according to Embodiment 2 of this application;
FIG. 16 is a diagram of a chip package structure in a production process according to Embodiment 2 of this application;
FIG. 17 is a diagram of a chip package structure in a production process according to Embodiment 2 of this application;
FIG. 18 is a diagram of a chip package structure according to Embodiment 3 of this application;
FIG. 19A to FIG. 19D are a diagram of a chip package structure in a production process according to Embodiment 3 of this application;
FIG. 20A to FIG. 20C are a diagram of a chip package structure in a production process according to an embodiment of this application;
FIG. 21 is a diagram of a chip package structure in a production process according to an embodiment of this application; and
FIG. 22 is a diagram of a chip package structure in a production process according to an embodiment of this application.

### DESCRIPTION OF EMBODIMENTS

To make objectives, technical solutions, and advantages of this application clearer, the following clearly and fully describes the technical solutions in this application with reference to accompanying drawings in this application. It is clear that the described embodiments are some but not all of embodiments of this application. All other embodiments obtained by a person of ordinary skill in the art based on embodiments of this application without creative efforts shall fall within the protection scope of this application.

In the specification, embodiments, claims, and accompanying drawings of this application, the terms "first", "second", and the like are merely intended for distinguishing and description, and shall not be understood as indicating or implying relative importance, or indicating or implying a sequence. The term "and/or" is used to describe an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one (item)" means one or more, and "a plurality of" means two or more. "Mounting", "connection", "interconnection", and the like should be understood in a broad sense, for example, may be an electrical connection or a mechanical connection; may be a fixed connection, a detachable connection, or an integrated connection; or may be a direct connection, an indirect connection through an intermediate medium, or communication between interiors of two elements. In addition, the terms "include" and "have" and any variants thereof are intended to cover non-exclusive inclusion, for example, include a series of steps or units. A method, system, product, or device is not necessarily limited to those steps or units that are expressly listed, but may include other steps or units that are not expressly listed or inherent to such a process, method, product, or device. "Upper", "lower", "left", "right", and the like are used only relative to orientation of components in the accompanying drawings. These directional terms are relative concepts, are used for relative descriptions and clarifications, and may change accordingly as positions at which the components in the accompanying drawings are placed change.

An embodiment of this application provides an electronic device. The electronic device may be a consumer electronic product, a home electronic product, a vehicle-mounted electronic product, a financial terminal product, a communication electronic product, or the like. This is not limited in this application.

For example, the consumer electronic product may be a mobile phone (mobile phone), a tablet computer (tablet computer), a notebook computer, a personal computer (personal computer, PC), a personal digital assistant (personal digital assistant, PDA), a smart wearable product (for example, a smart watch or a smart band), a virtual reality (virtual reality, VR) terminal device, an augmented reality (augmented reality, AR) terminal device, or an uncrewed aerial vehicle. The home electronic product may be a smart door lock, a television, a smart speaker, a refrigerator, a robotic vacuum cleaner, or the like. The vehicle-mounted electronic product may be a vehicle-mounted navigator, a vehicle-mounted display, or the like. The financial terminal product may be an automated teller machine (automated teller machine, ATM), an electronic device for self-help service handling, or the like. The communication electronic product may be a device, for example, a communication device like a server, a memory, a radar, or a base station.

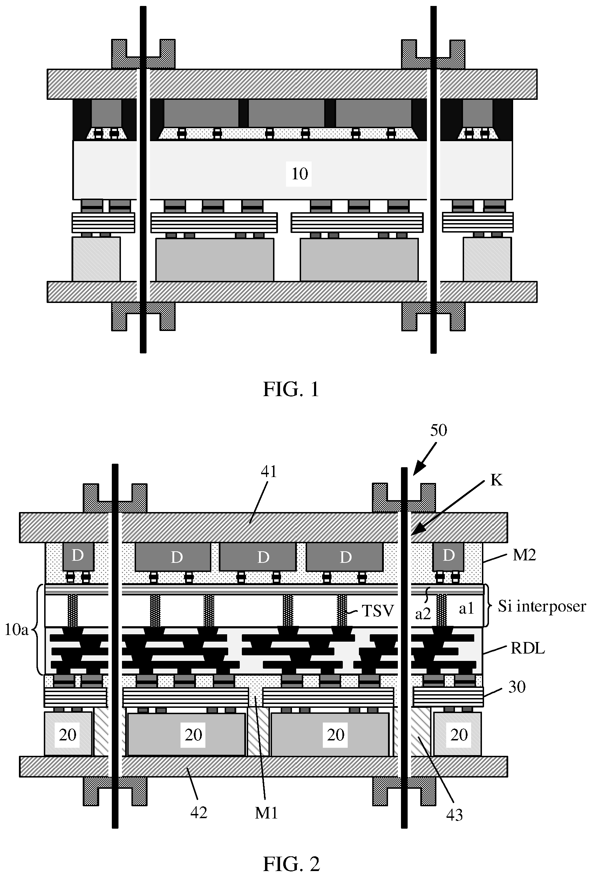

The electronic device includes a circuit board (printed circuit board, PCB, which may also be referred to as a printed wiring board) and a chip package structure electrically connected to the circuit board. For example, the chip package structure may be a system in package structure. As shown in FIG. 1, a hybrid interposer 10 of a new type is used in the chip package structure. Using the hybrid interposer 10 can meet a requirement of high bandwidth density between chips while supporting heterogeneous chip (die) integration.

For example, in some possible implementations, the hybrid interposer 10 provided in this embodiment of this application can implement interconnection bandwidth density of more than 2 Tbps/mm.

An application scenario of the chip package structure is not limited in this application. For example, the chip package structure may be used in scenarios such as a large server, a high-bandwidth switch, and an AI computing supercomputer.

The following specifically describes, with reference to specific embodiments, the hybrid interposer 10 of the new type used in the chip package structure provided in this application.

### Embodiment 1

For example, as shown in FIG. 2, Embodiment 1 provides a chip package structure. The chip package structure includes a hybrid interposer 10a, at least one chip D (which may also be referred to as a first chip), and at least one electronic element 20. The following uses a plurality of chips D and a plurality of electronic elements 20 as an example for description.

The chip D may be a central processing unit (central processing unit, CPU), a graphics processing unit (graphics processing unit, GPU), a memory (memory), an input/output (I/O) chip, an integrated passive device (integrated passive device, IPD), or the like, or may be integrated with another packaged functional module, for example, an HBM (high bandwidth memory, high bandwidth memory), a DOI (die on silicon interposer, die on silicon interposer), or an FOI (fan out RDL interposer, fan out RDL interposer). In practice, a plurality of chips D may be disposed based on a requirement.

The electronic element 20 may be a power supply module, a control module, a connector, a clock device, a rectifier, a resistor, a resistor-capacitor-inductor, or the like. The power supply module may be a VRM (voltage regulator module, voltage regulator module) or another related module like an electrical transmission module, a voltage transformation module, or a rectification module. The connector may be an electrical connector for transmitting an electrical signal, or may be a photoelectric conversion connector for transmitting an optical signal. In practice, the plurality of electronic elements 20 may be disposed based on a requirement.

As shown in FIG. 2, the hybrid interposer 10a includes a silicon interposer (Si interposer) and a redistribution layer RDL (redistribution layer).

As shown in FIG. 2, the silicon interposer (Si interposer) includes a silicon wafer (wafer) a1 and a metal routing layer a2 disposed on a surface (a surface on a side away from the RDL) of the silicon wafer a1. A plurality of through silicon vias TSVs (through silicon vias) are disposed in the silicon wafer a1. The metal routing layer a2 is connected to the plurality of through silicon vias TSVs. For example, via diameters of the plurality of through silicon vias TSVs may range from 1 µm to 30 µm.

In this application, a front surface of the silicon interposer (Si interposer) is a surface of a side that is of the silicon interposer and on which the metal routing layer a2 is disposed. A back surface of the silicon interposer (Si interposer) is a surface on a side that is of the silicon wafer a1 and on which the metal routing layer a2 is not disposed, namely, a back surface (a surface on a side away from the metal routing layer a2) of the silicon wafer a1.

The redistribution layer RDL (redistribution layer) is located on the back surface of the silicon wafer (wafer) a1 (namely, the surface on the side away from the metal routing layer a2), and the redistribution layer RDL is connected to the metal routing layer a2 through the plurality of through silicon vias TSVs in the silicon wafer a1.

The plurality of chips D are disposed on the front surface of the silicon interposer (Si interposer), and is electrically connected to a connection pad disposed on the front surface of the silicon interposer (Si interposer).

The plurality of electronic elements 20 are disposed below the redistribution layer RDL, and are electrically connected to the redistribution layer RDL, to be electrically connected to the plurality of chips D through the redistribution layer RDL and the silicon interposer (Si interposer).

In Embodiment 1, the metal routing layer a2 on the surface of the silicon interposer (Si interposer) may be processed by using a silicon-based process, so that a metal trace in the metal routing layer a2 has a small trace width, trace spacing, and trace thickness, to meet an interconnection requirement of high bandwidth density between the plurality of chips D, for example, interconnection bandwidth density greater than 2 Tbps/mm. For example, in some possible implementations, the metal routing layer a2 may be implemented by using a Damascus process including processes such as deposition, exposure, etching, electroplating, and chemical mechanical polishing (chemical mechanical polishing, CMP).

For example, the trace width, the trace spacing, and the trace thickness of the metal routing layer a2 may reach 0.4 µm, and a quantity of layers may be processed to more than 3.

For example, in some possible implementations, the trace width of the metal routing layer a2 may be less than 5 µm, but this is not limited thereto.

For example, in some possible implementations, the trace thickness (namely, a thickness of a single layer of metal) of the metal routing layer a2 may be less than 5 µm, but this is not limited thereto.

For example, in some possible implementations, the trace spacing of the metal routing layer a2 may be less than 5 µm, but this is not limited thereto.

For example, in some possible implementations, the metal routing layer a2 may include 3 to 10 wiring layers (which may also be referred to as metal wiring layers), but this is not limited thereto.

For example, in some possible implementations, copper (Cu) may be used for the wiring layer in the metal routing layer a2, but this is not limited thereto.

For example, in some possible implementations, a dielectric layer in the metal routing layer a2 may use one or more of insulation medium materials such as polyimide (polyimide, PI), polybenzoxazole (polybenzoxazole, PBO), silicon dioxide SiO2, silicon nitride SiN, and silicon carbon nitrogen SiCN, but this is not limited thereto.

For example, in some possible implementations, a thickness of the dielectric layer in the metal routing layer a2 may range from 0.1 µm to 5 µm, but this is not limited thereto.

For example, in some possible implementations, a plurality of micro pads (solder joints) may be disposed on the surface of the metal routing layer a2, and a spacing between the micro pads may range from 10 µm to 200 µm. The metal routing layer a2 is soldered to the plurality of chips D through the plurality of micro pads. In some connection manners in which interconnection is implemented without soldering, for example, HB (Hybrid bonding, hybrid direct bonding), a spacing between connection points of the metal routing layer and the chip may even be reduced to an order of magnitude of 1 µm to 10 µm.

In addition, as shown in FIG. 2, the redistribution layer RDL may use a thick metal layer and a thick dielectric layer that have a better current equalization capability. For example, a trace width, a trace spacing, and a trace thickness of the metal trace in the redistribution layer RDL may be greater than 5 µm, to meet a requirement of the electronic element 20 for driving a high-speed serdes (serializer/deserializer, serializer/deserializer) with a large current equalization capability, low impedance, and a long spacing (for example, more than 5 mm).

For example, in some possible implementations, the redistribution layer RDL may be implemented by using a yellow light process including processes such as glue coating/film attachment, exposure, development, and curing.

For example, in some possible implementations, the trace width of the redistribution layer RDL may range from 5 µm to 30 µm, but this is not limited thereto.

For example, in some possible implementations, the trace spacing of the redistribution layer RDL may range from 6 µm to 20 µm, but this is not limited thereto.

For example, in some possible implementations, the trace thickness of the redistribution layer RDL may range from 6 µm to 20 µm, but this is not limited thereto.

For example, in some possible implementations, the redistribution layer RDL may include three to six wiring layers, but this is not limited thereto.

For example, in some possible implementations, a thickness of the dielectric layer in the redistribution layer RDL may range from 10 µm to 40 µm, but this is not limited thereto.

For example, in some possible implementations, copper (Cu) may be used for the wiring layer in the redistribution layer RDL, but this is not limited thereto.

For example, in some possible implementations, the dielectric layer in the redistribution layer RDL may use one or more of dielectric materials such as polyimide (polyimide, PI), benzocyclobutene (benzocyclobutene, BCB), or polybenzoxazole (polybenzoxazole, PBO), but this is not limited thereto.

For example, in some possible implementations, a plurality of large pads may be disposed on a lower surface of the redistribution layer RDL, a spacing between the large pads may range from 200 µm to 1500 µm, and the redistribution layer RDL is electrically interconnected to the plurality of electronic elements 20 through the plurality of large pads. The redistribution layer RDL may be electrically interconnected to the electronic elements 20 through soldering, crimping, insertion, or the like.

In conclusion, the hybrid interposer 10a of the new type provided in Embodiment 1 includes the silicon interposer (Si interposer) and the redistribution layer RDL. The metal routing layer a2 with the small trace width/trace spacing/trace thickness is formed on the surface of the silicon interposer (Si interposer), to meet an interconnection requirement of high bandwidth density between the chips D. In addition, the redistribution layer RDL uses the thick metal layer and the thick dielectric layer, to meet requirements of the electronic element 20 for large current equalization and long routing capabilities. In other words, the hybrid interposer 10a of the new type can integrate a medium that implements the high bandwidth density with two media that implement the large current equalization and long routing capabilities. In this way, a package structure using the hybrid interposer 10a of the new type can support high bandwidth density between heterogeneous chips, and also support a long-spacing serdes driving capability, thereby meeting an integration requirement of a large system and improving system energy utilization and computational power efficiency.

A manner of connecting the plurality of electronic elements 20 to the redistribution layer RDL is not limited in this application. The plurality of electronic elements 20 may be directly connected to the redistribution layer RDL, or may be indirectly connected to the redistribution layer RDL through another device. In practice, the connection manner may be set based on a requirement.

For example, in some possible implementations, the electronic element 20 may be directly connected to the lower surface of the redistribution layer RDL.

For example, in some possible implementations, the plurality of electronic elements 20 may be connected to the lower surface of the redistribution layer RDL through a substrate. The substrate may be located between the electronic elements 20 and the redistribution layer RDL of the redistribution layer RDL.

The substrate may be made by using one or more of a substrate process, a carrier plate-like process, or a printed circuit board (printed circuit board, PCB) process. This is not limited in this application.

To meet the electrical requirement of the plurality of electronic elements 20, in some possible implementations, as shown in FIG. 2, a plurality of discrete substrates 30 may be used, and layers and specifications of the plurality of substrates 30 may not be completely the same. In this case, the plurality of electronic elements 20 may be connected to the redistribution layer RDL through the plurality of discrete substrates 30. One electronic element 20 or a plurality of electronic elements 20 may be mounted on a single substrate 30 that is disposed separately. This is not limited in this application, and the electronic element may be disposed based on a requirement in practice. In this way, types of the plurality of substrates 30 can be flexibly selected based on an electrical requirement of the electronic element 20, to improve performance of an entire system. For example, a multi-layer substrate may be configured only for an electronic element 20 that requires a complex multi-layer substrate, and a simple substrate may be configured for an electronic element 20 that requires a simple substrate.

In addition, using the plurality of discrete substrates 30 can further alleviate mechanical stress caused by thermal mismatch in an assembly and service scenario caused by one large continuous substrate, and is friendlier to system assembly and service reliability. A manner of electrically connecting the substrate 30 to the redistribution layer RDL is not limited in this application, and may be set based on a requirement in practice.

For example, in some possible implementations, the plurality of substrates 30 may be connected to the redistribution layer RDL in one or a combination of connection manners such as soldering, crimping, and insertion.

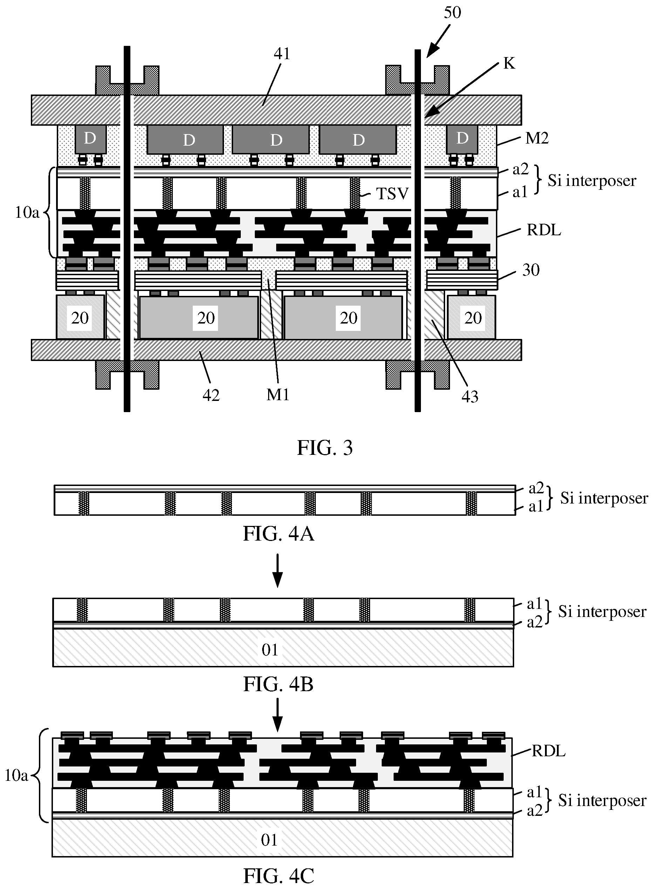

To protect the plurality of substrates 30, as shown in FIG. 3, in some possible implementations, bottoms of the plurality of substrates 30 and a gap between the substrates 30 may be filled with a thermocurable material, and after the filling, a back surface of the substrate 30 and a connection structure (for example, a Cu stud) may be exposed through grinding, to form a molding layer M1 to protect the plurality of substrates 30.

The thermocurable material in this application may include an underfill (underfill, UF) material, a molded underfill (molded underfill, MUF) material, an epoxy molding compound (epoxy molding compound), and the like. This is applied to the following descriptions, and details are not described again.

Similarly, to protect the plurality of chips D, in some possible implementations, as shown in FIG. 2 or FIG. 3, a thermocurable material may be used to first perform filling protection on bottoms of the plurality of chips D in an underfill (underfill) manner, and then coat the plurality of chips D in a molding layer M2 in a molding (molding or molding underfill) manner to form protection.

In addition, in some possible implementations, as shown in FIG. 2 or FIG. 3, a first heat dissipation panel 41 and a second heat dissipation panel 42 may be further disposed in the chip package structure. The first heat dissipation panel 41 is disposed on a side that is of the plurality of chips D and that is away from the hybrid interposer 10a, and the second heat dissipation panel 42 is disposed on a side that is of the plurality of electronic elements 20 and that is away from the hybrid interposer 10a. Two heat dissipation panels (41 and 42) are disposed to meet heat dissipation of the chip package structure.

For example, a gap between the chip D and the first heat dissipation panel 41 may be filled with a thermal interface material (TIM, thermal interface material). The TIM may be a heat dissipation medium like a thermal adhesive, thermal grease, graphene, or liquid metal. This is not limited herein. Similarly, a gap between the electronic element 20 and the second heat dissipation panel 42 may also be filled with the TIM.

A disposing form of the heat dissipation panels (41 and 42) is not limited in this application. In practice, the heat dissipation panel may be disposed based on a requirement.

For example, in some possible implementations, the heat dissipation panels (41 and 42) may be metal covers.

For another example, in some possible implementations, the heat dissipation panels (41 and 42) may be of a hollow structure, to support water cooling or liquid cooling for heat dissipation.

For another example, the heat dissipation panels (41 and 42) may have a hollow-out structure like a via structure or a grid. In this case, the heat dissipation panel can support vertical interconnection between an external power supply system and the electronic element 20 on the back surface of the chip through a hollow-out region while meeting a heat dissipation requirement.

In the package structure, thicknesses, materials, and structures of the first heat dissipation panel 41 and the second heat dissipation panel 42 may be the same or different. This is not limited in this application.

In addition, as shown in FIG. 3, in some possible implementations, to ensure balanced force inside the chip package structure, a support frame 43 may be disposed in the chip package structure, and the support frame 43 is located in a gap between the electronic elements 20. In addition, an upper end of the support frame 43 may be in contact with the substrate 30, and a lower end of the support frame 43 may be in contact with the second heat dissipation panel 42. On this basis, to fasten the first heat dissipation panel 41, the second heat dissipation panel 42, the support frame 43, and a package system, as shown in FIG. 2 or FIG. 3, in some possible implementations, a fastening structure 50 may be disposed in the chip package structure, the fastening structure 50 penetrates the first heat dissipation panel 41, the second heat dissipation panel 42, the support frame 43, and the hybrid interposer 10a, and fastens the first heat dissipation panel 41, the second heat dissipation panel 42, the support frame 43, and the hybrid interposer 10a.

For example, as shown in FIG. 2 or FIG. 3, in some possible implementations, the fastening structure 50 may include a bolt and a nut. The bolt penetrates the first heat dissipation panel 41, the second heat dissipation panel 42, and the hybrid interposer 10a, and the nut is fastened at an end of the bolt, to fasten the first heat dissipation panel 41, the second heat dissipation panel 42, and the hybrid interposer 10a. In this case, the first heat dissipation panel 41 and the second heat dissipation panel 42 not only dissipate heat, but also stabilize a structure.

Certainly, another device or component structure may be further disposed in the chip package structure based on an actual requirement.

The following further describes the chip package structure with reference to a production method of the chip package structure.

For example, Embodiment 1 provides a production method of the chip package structure. The production method may include the following steps.

First, as shown in FIG. 4A, the silicon wafer (wafer) a1 is provided, and the plurality of through silicon vias TSVs are made on the silicon wafer a1. In addition, the metal routing layer a2 and the like are made on the surface of the silicon wafer a1 by using the Damascus process including processes such as deposition, exposure, etching, electroplating, and CMP, to form the silicon interposer (Si interposer).

After the plurality of metal wiring layers in the metal routing layer a2 are made, micro pads are made on the surface for subsequent soldering with the chip D. A spacing between the micro pads may range from 10 µm to 200 µm. For related descriptions, refer to the foregoing descriptions. Details are not described herein again.

Next, as shown in FIG. 4B and FIG. 4C, a side that is of the silicon interposer (Si interposer) and on which the metal routing layer a2 is disposed is fastened to a first carrier plate 01, and the redistribution layer RDL is made on the back surface of the silicon wafer a1, to form the hybrid interposer 10a.

A carrier plate (for example, the first carrier plate or a second carrier plate) in this application may be a support like a metal plate or glass. This is not limited in this application, and the carrier plate may be disposed based on a requirement in practice.

For example, in some possible implementations, the process of forming the redistribution layer RDL may include: As shown in FIG. 4A, the side that is of the silicon interposer (Si interposer) and on which the metal routing layer a2 is disposed may be fastened to the glass carrier plate (01) through temporary bonding, and the back surface of the silicon wafer a1 is thinned to a required thickness (for example, 10 µm to 300 µm) and the through silicon via TSV is exposed by using a grinding process, a chemical mechanical polishing (chemical mechanical polishing, CMP) process, or the like. Then, an insulation film may be processed in a manner like PVD (physical vapor deposition, physical vapor deposition), CVD (chemical vapor deposition, chemical vapor deposition), spin coating of a liquid adhesive, or film attachment, where a material may be an insulation material like PI, PBO, SiO₂, or SiN. Next, as shown in FIG. 4B, a metal layer and a dielectric layer are made and grown on the insulation film to make the redistribution layer RDL. A specific production process of the redistribution layer RDL may include surface preprocessing and organic material coating-exposure-development-curing-seed layer precipitation-organic material coating-exposure-development-electroplating-photoresistance removal-seed layer etching, and the like. After the plurality of metal wiring layers, the large pads are processed for subsequent soldering with the electronic element 20. A spacing between centers of adjacent large pads may range from 200 µm to 1500 µm.

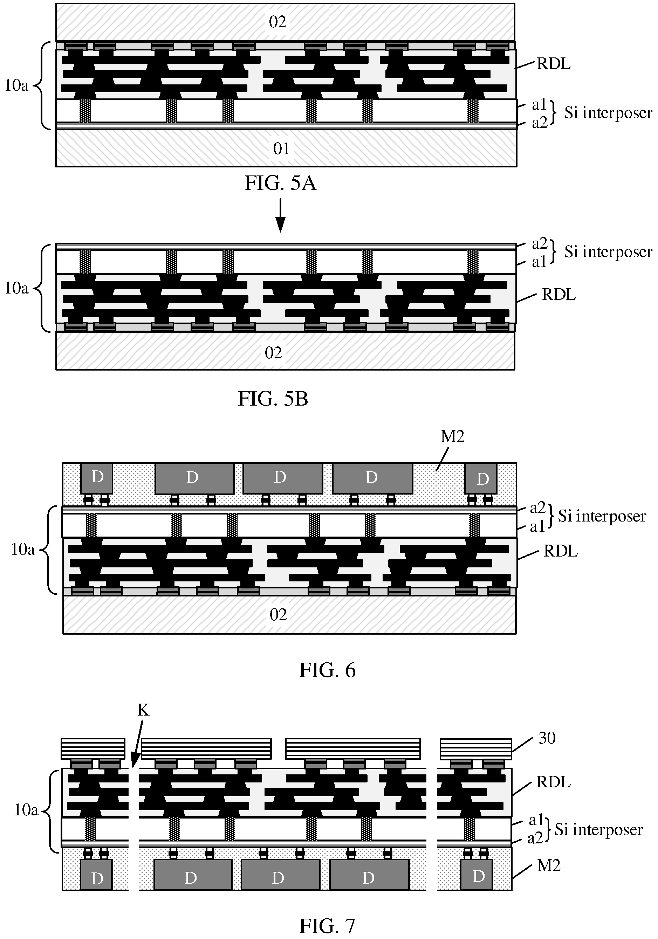

Next, as shown in FIG. 5A and FIG. 5B, a side that is of the hybrid interposer 10a and on which the redistribution layer RDL is disposed may be fastened to the second carrier plate 02 (for example, glass) through temporary bonding. Then, the first carrier plate 01 on the other side may be debonded and separated from the hybrid interposer 10a through laser burning, heat treatment, or the like, and a micro pad interface on the surface of the silicon interposer (Si interposer) is exposed.

Next, as shown in FIG. 6, the plurality of chips D (for example, a plurality of heterogeneous chips D) may be mounted on the surface of the silicon interposer (Si interposer), and the chips D are soldered to micro pads on the surface of the silicon interposer (Si interposer). Then, the bottoms of the chips and the gap between the chips may be filled with the thermocurable material, and then grinding (backside grinding) may be performed on back surfaces of the plurality of chips D, to expose the back surfaces of the chips, so as to form the molding layer M2 to protect the plurality of chips D.

Next, as shown in FIG. 7, the second carrier plate 02 may be removed to expose the pad on the surface of the redistribution layer RDL. For example, in some possible implementations, the second carrier plate 02 may be debonded and separated from the hybrid interposer 10a through laser burning, heat treatment, or the like, and a pad interface on the surface of the redistribution layer RDL is exposed.

Next, as shown in FIG. 7, the plurality of substrates 30 are soldered to the pads exposed on the surface of the redistribution layer RDL, and the plurality of electronic elements 20 are respectively soldered to other sides of the plurality of substrates 30.

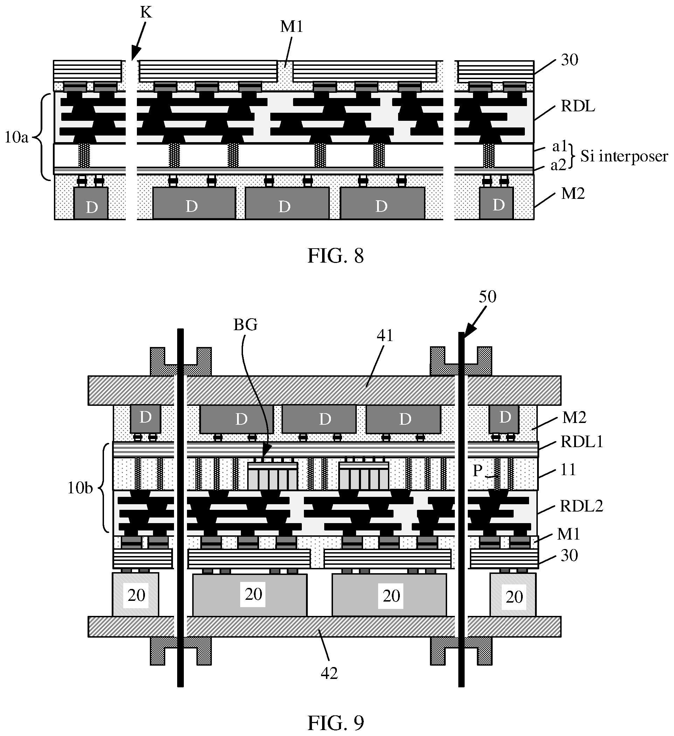

Next, as shown in FIG. 7, opening processing is performed on a non-routing region of the hybrid interposer 10a to form a via K, where a hole diameter of the via K may range from 2 mm to 8 mm, so that during final system assembly, the fastening structure 50 (for example, the bolt) penetrates the hybrid interposer 10a through the via K, to form reliable mechanical support. Certainly, in some possible implementations, as shown in FIG. 8, after the plurality of substrates 30 are soldered to the pads on the surface of the redistribution layer RDL, the bottoms of the plurality of substrates 30 and the gap between the substrates 30 may be filled with the thermocurable material, and the back surface of the substrate 30 and the connection structure (for example, the Cu stud) are exposed through grinding, to form the molding layer M1 to protect the plurality of substrates 30. After the molding layer M1 is formed, opening processing is performed on the non-routing region of the hybrid interposer 10a to form the via K.

Certainly, in some special scenarios, the electronic element 20 may be directly soldered to the surface of the redistribution layer RDL based on an actual requirement, to form electrical interconnection.

Next, the support frame 43 matching a size of a hybrid interposer system (namely, a system including the plurality of chips D, the hybrid interposer 10, the plurality of electronic elements 20, and the plurality of substrates 30) may be used to support the hybrid interposer system. Certainly, opening processing is also performed on the support frame 43 at a position at which the via is disposed in the hybrid interposer system.

Next, as shown in FIG. 3, under support of the support frame 43, the first heat dissipation panel 41 may be mounted on a side that is of the hybrid interposer system and on which the chips D are located, and the second heat dissipation panel 42 may be mounted on a side on which the electronic elements 20 are located. Certainly, opening processing is also performed on the heat dissipation panels (41 and 42) at a position at which the via is disposed in the hybrid interposer system. The bolt (50) penetrates the hybrid interposer system, the support frame, the first heat dissipation panel 41, and the second heat dissipation panel 42 at the position of the via, and is fastened. In this case, the heat dissipation panels (41 and 42) not only dissipate heat, but also stabilize the structure.

By now, the entire package system has been constructed, and is an independent data processing unit, where a required power supply may be provided for the system through an external power supply module, and a signal of the system may be led out through a cable connector.

### Embodiment 2

Embodiment 2 provides a chip package structure. A main difference between the chip package structure and Embodiment 1 lies in that a structure of a hybrid interposer is different, and settings of other parts (such as a chip D and an electronic element 20) are basically the same. For details, refer to the descriptions in Embodiment 1. Details are not described herein again.

The following describes a structure of a hybrid interposer of a new type provided in Embodiment 2.

For example, as shown in FIG. 9, a hybrid interposer 10b of a new type is used in the chip package structure provided in Embodiment 2, and the hybrid interposer 10b includes: a first redistribution layer RDL1, a second redistribution layer RDL2, and at least one bridge die BG (bridge die) and a plurality of metal posts P (for example, copper posts (Cu posts)) that are connected between the first redistribution layer RDL1 and the second redistribution layer RDL2. The bridge die BG and the metal post P are molded in a molding layer to form a molding interposer 11. The first redistribution layer RDL1 is disposed on an active surface of the bridge die BG, and is electrically connected to the active surface of the bridge die BG. The second redistribution layer RDL2 is electrically connected to the first redistribution layer RDL1 through the metal post P.

In addition, based on an actual requirement, in some possible implementations, the bridge die BG may be provided with a through silicon via. In this case, the through silicon via in the bridge die BG is electrically connected to the second redistribution layer RDL2 below.

A structure of the bridge die BG is similar to that of the Si interposer in Embodiment 1. Because the bridge die BG may be made by using a silicon-based process, a trace width, a trace spacing, and a trace thickness of a surface of the bridge die BG may be less than 5 µm. Therefore, an interconnection requirement of high bandwidth density between a plurality of chips D can be met.

As shown in FIG. 9, the plurality of chips D are disposed on an upper surface of the first redistribution layer RDL1 (namely, a surface on a side away from the bridge die BG), and are electrically connected to the first redistribution layer RDL1. The bridge die BG is located at a position between two adjacent chips D. In this case, the bridge die implements a connection between the two adjacent chips D through the first redistribution layer. Any two adjacent chips D may be interconnected through the bridge die BG.

The plurality of electronic elements 20 are located below the second redistribution layer RDL2 (namely, on a side away from the bridge die BG). The electronic element 20 may be directly connected to a lower surface of the second redistribution layer RDL2, or may be connected to the lower surface of the second redistribution layer RDL2 through a substrate 30. For example, the plurality of electronic elements 20 may be separately connected to the second redistribution layer RDL2 through different substrates 30. For details, refer to corresponding descriptions in Embodiment 1. Details are not described herein again.

For the first redistribution layer RDL1 and the second redistribution layer RDL2:

The first redistribution layer RDL1 may use a thin metal layer and a thin dielectric layer. For example, a trace width/trace spacing/trace thickness may be less than 5 µm. In this case, the first redistribution layer RDL1 may directly lead out a connection pad on the surface of the bridge die BG in a region of the bridge die BG, so that an interconnection requirement of high bandwidth density between the chips D can be met by using the bridge die BG.

For example, the first redistribution layer RDL1 may be implemented by using a Damascus process including deposition, exposure, etching, electroplating, and CMP.

The second redistribution layer RDL2 may be provided with a thick metal layer and a thick dielectric layer that are used as the redistribution layer RDL. For example, a trace width/trace spacing/trace thickness may be greater than 5 µm, to meet requirements of the electronic element 20 for large current equalization and long routing capabilities.

For example, the second redistribution layer RDL2 may be implemented by using a yellow light process including glue coating/film attachment, exposure, development, and curing.

For example, the first redistribution layer RDL1 may include one to three wiring layers, but this is not limited thereto.

For example, the second redistribution layer RDL2 may include three to six wiring layers, but this is not limited thereto.

For other parts in the chip package structure, such as the substrate 30, a first heat dissipation panel 41, a second heat dissipation panel 42, and a fastening structure 50, refer to corresponding parts in Embodiment 1. Details are not described herein again.

The following further describes the chip package structure in Embodiment 2 with reference to a production method of the chip package structure.

For example, Embodiment 2 provides a production method of the chip package structure. The production method may include the following steps.

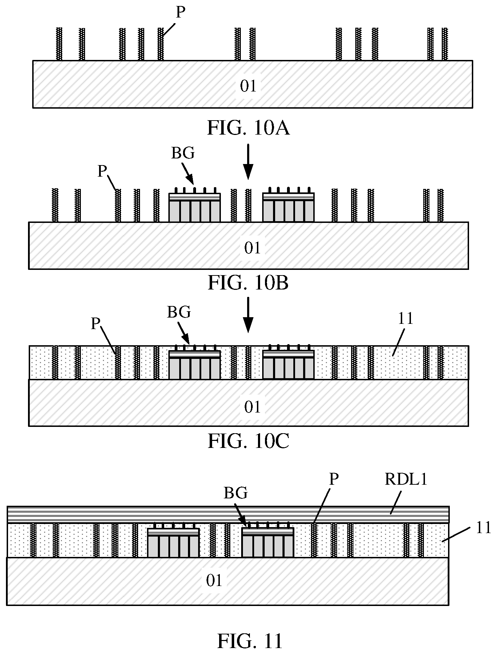

First, as shown in FIG. 10A, the metal post P, for example, a copper post (Cu post), is made on a front surface of a first carrier plate 01 (for example, a glass wafer (glass wafer)), and is used as a conductive connecting piece. Then, as shown in FIG. 10B, the at least one bridge die BG is mounted on the front surface (namely, a side on which P is disposed) of the first carrier plate 01. Next, as shown in FIG. 10C, molding is performed on the front surface of the first carrier plate 01 by using a thermocurable material, the metal post P and the entire body are molded into a molding layer, and the metal post P and a connection structure (for example, a Cu stud) on the surface of the bridge die BG is exposed through grinding, to form a molding interposer (interposer) 11.

Next, as shown in FIG. 11, the first redistribution layer RDL1 is made on an upper surface of the molding interposer 11. An interconnection material in the first redistribution layer RDL1 may be Cu, and an insulation medium material may be a polyimide (polyimide, PI), benzocyclobutene (benzocyclobutene, BCB), polybenzoxazole (polybenzoxazole, PBO), or another material. For example, a production process of a single routing layer in the first redistribution layer RDL1 includes: surface preprocessing-PI coating-exposure-development-curing-seed layer precipitation-photoresistance (PR) coating-exposure-development-electroplating-photoresistance removal-seed layer etching.

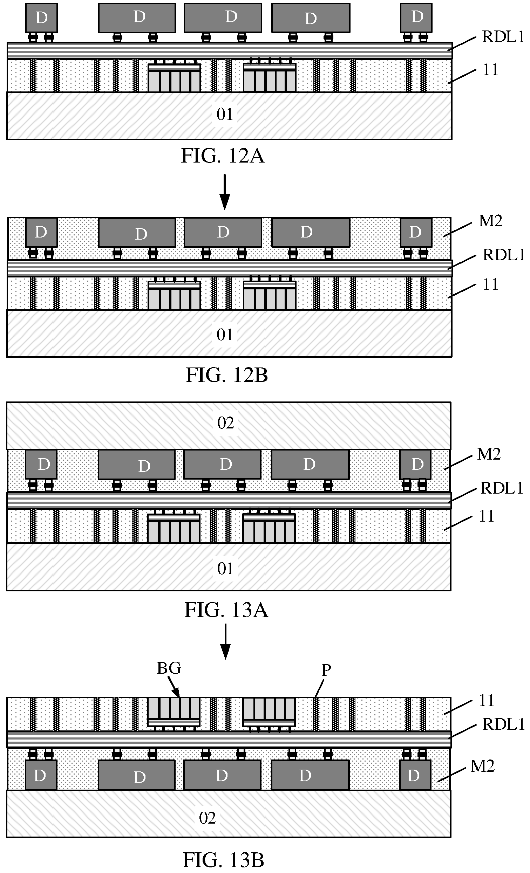

Next, as shown in FIG. 12A, the plurality of heterogeneous chips D may be mounted on the surface of the first redistribution layer RDL1. Then, as shown in FIG. 12B, bottoms of the plurality of chips and a gap between the chips are filled with a thermocurable material, and then grinding (backside grinding) may be performed on back surfaces of the plurality of chips D, to expose the back surfaces of the chips, so as to form a molding layer M2 to protect the plurality of chips D.

Next, as shown in FIG. 13A, a back surface side of the plurality of chips D is temporarily bonded to a second carrier plate 02 (for example, a glass plate or a metal plate). Then, as shown in FIG. 13B, the first carrier plate 01 on the other side may be debonded and separated through laser burning, heat treatment, or the like (for example, laser debonding or pyrolytic bonding), and the metal post P and the bridge die BG are exposed through grinding. The grinding process may include: grinding (grinding)-chemical mechanical polishing (chemical mechanical polishing, CMP)-Si etching (etch) copper exposure-insulation medium material deposition-CMP copper exposure, and the like.

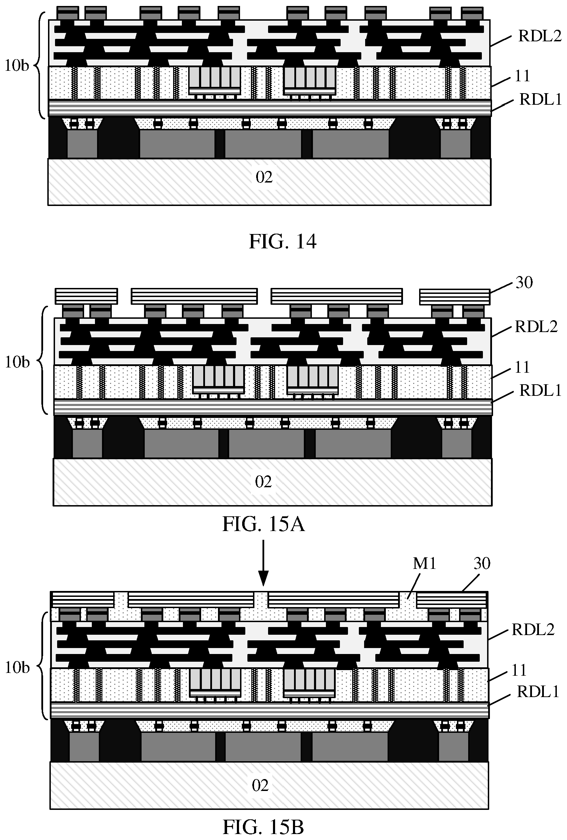

Next, as shown in FIG. 14, the second redistribution layer RDL2 is made on a back surface of the wafer (wafer) (namely, a side on which the metal post P and the bridge die BG are exposed). An interconnection material in the second redistribution layer RDL2 may be Cu, and an insulation medium material may be a polyimide (polyimide, PI), benzocyclobutene (benzocyclobutene, BCB), polybenzoxazole (polybenzoxazole, PBO), or another material. For example, a production process of a single routing layer in the second redistribution layer RDL2 includes: surface preprocessing-PI coating-exposure-development-curing-seed layer precipitation-photoresistance (PR) coating-exposure-development-electroplating-photoresistance removal-seed layer etching.

In this case, the hybrid interposer 10b formed by the first redistribution layer RDL1, the molding interposer 11 embedded with the metal post P and the bridge die BG, and the second redistribution layer RDL2 is made.

Next, as shown in FIG. 15A, the plurality of substrates 30 may be soldered to pads on the surface of the second redistribution layer RDL2. For example, a plurality of ABF (ajinomoto build-up film, ajinomoto build-up film) substrates may be flipped on the surface of the second redistribution layer RDL2. Certainly, as shown in FIG. 15B, after the plurality of substrates 30 are soldered based on a requirement, bottoms of the plurality of substrates 30 and a gap between the substrates 30 may be filled with a thermocurable material, and a back surface of the substrate 30 and a connection structure (for example, a Cu stud) are exposed through grinding, to form a molding layer M1 to protect the plurality of substrates 30.

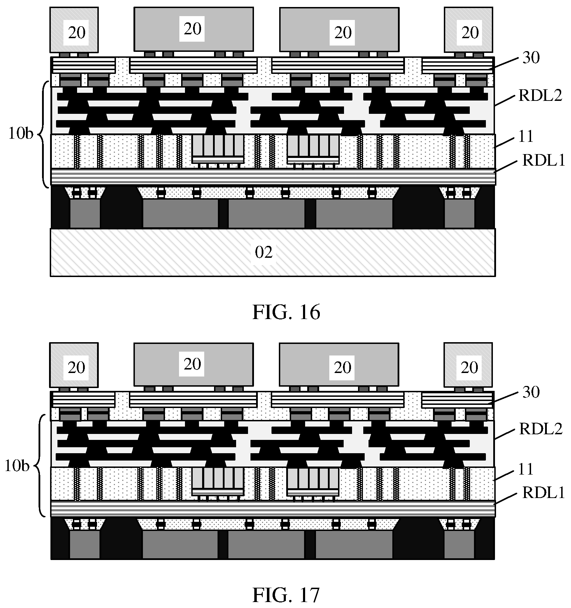

Next, as shown in FIG. 16, a plurality of electronic elements 20 (for example, functional modules such as a power assembly, a clock, and a passive component) are separately soldered to surfaces of the plurality of substrates 30, to implement vertical power supply interconnection between the electronic elements 20 and the substrates 30.

Next, as shown in FIG. 17, the second carrier plate 02 is debonded and separated through laser burning, heat treatment, or the like.

After this, a production process like opening processing, cutting, and mounting of the first heat dissipation panel 41, the second heat dissipation panel 42, the support frame 43, and the fastening structure 50 is performed on a non-routing region of the hybrid interposer 10b. For details, refer to the related descriptions in Embodiment 1. Details are not described herein again.

### Embodiment 3

Embodiment 3 provides a chip package structure. A hybrid interposer used in the chip package structure is similar to the hybrid interposer 10b in Embodiment 2, and a difference lies only in that materials of an interposer on which a bridge die BG is disposed are different.

The following describes a structure of a hybrid interposer of a new type provided in Embodiment 3.

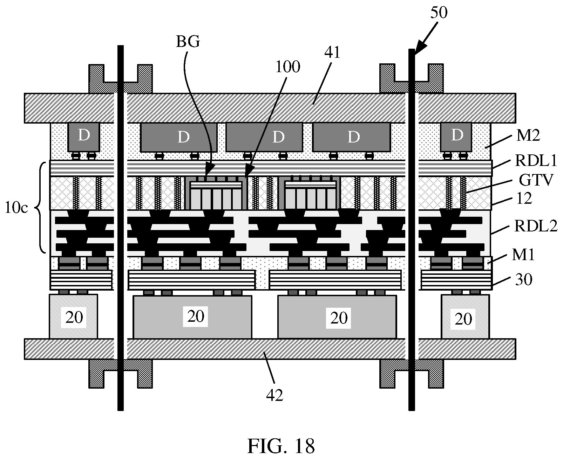

For example, as shown in FIG. 18, a hybrid interposer 10c of a new type is used in the chip package structure provided in Embodiment 3, and the hybrid interposer 10c includes: a first redistribution layer RDL1, a second redistribution layer RDL2, and a glass interposer 12 disposed between the first redistribution layer RDL1 and the second redistribution layer RDL 2. A plurality of through glass vias TGVs (through glass vias) and at least one trench 100 are disposed in the glass interposer 12, and the bridge die BG (bridge die) is disposed in the trench 100. The bridge die BG and the through glass via TGV are connected between the first redistribution layer RDL1 and the second redistribution layer RDL2. The first redistribution layer RDL1 is disposed on an active surface of the bridge die BG, and is electrically connected to the active surface of the bridge die BG. The second redistribution layer RDL2 is electrically connected to the first redistribution layer RDL1 through the through glass via TGV.

In addition, based on an actual requirement, in some possible implementations, the bridge die BG may be provided with a through silicon via. In this case, the through silicon via in the bridge die BG is electrically connected to the second redistribution layer RDL2 below.

In other words, in comparison with Embodiment 2 in which a dielectric layer on which the bridge die BG is disposed is a molding material (namely, the molding layer 11), in Embodiment 3, a dielectric layer on which the bridge die BG is disposed is a glass wafer.

In Embodiment 3, because the bridge die BG may be made by using a silicon-based process, a trace width/trace spacing/trace thickness can be less than 5 µm, to meet an interconnection requirement of high bandwidth density between a plurality of chips D.

The first redistribution layer RDL1 may use a thin metal layer and a thin dielectric layer. For example, a trace width/trace spacing/trace thickness may be less than 5 µm. In this case, the first redistribution layer RDL1 may lead out a connection pad on a surface of the bridge die BG in a region of the bridge die BG, so that an interconnection requirement of high bandwidth density between the chip D and the bridge die BG can be met.

For example, the first redistribution layer RDL1 may be implemented by using a Damascus process including processes such as deposition, exposure, etching, electroplating, and CMP.

The second redistribution layer RDL2 may be provided with a thick metal layer and a thick dielectric layer that are used as the redistribution layer RDL. For example, a trace width/trace spacing/trace thickness may be greater than 5 µm, to meet requirements of the electronic element 20 for large current equalization and long routing capabilities.

For example, the second redistribution layer RDL2 may be implemented by using a yellow light process including glue coating/film attachment, exposure, development, and curing.

For other related settings of the bridge die BG, the first redistribution layer RDL1, and the second redistribution layer RDL2 in Embodiment 3, refer to corresponding parts in Embodiment 2. Details are not described herein again.

For other parts in the chip package structure, such as the electronic element 20, the substrate 30, a first heat dissipation panel 41, a second heat dissipation panel 42, and a fastening structure 50, refer to corresponding parts in Embodiment 1 and Embodiment 2. Details are not described herein again.

The following further describes the chip package structure in this embodiment with reference to a production method of the chip package structure.

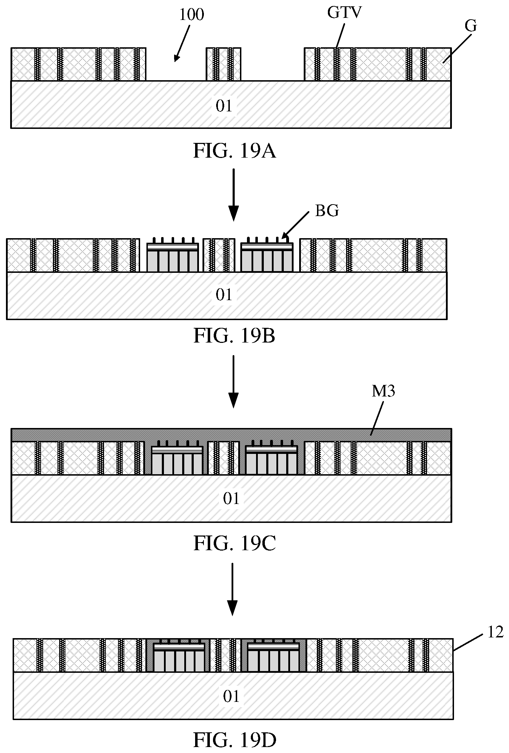

As shown in FIG. 19A, the through glass via TGV is made on the glass wafer (glass wafer) G, and the glass wafer G with the through glass via TGV is mounted on a surface of a first carrier plate 01. Then, the trench 100 may be provided on the glass wafer G in a manner like laser.

Next, as shown in FIG. 19B, the bridge die BG is mounted in a trench body of the trench 100.

Next, as shown in FIG. 19C, the trench 100 is filled with a thermocurable material, and covers a surface of the glass wafer G. Then, as shown in FIG. 19D, the through glass via TGV and the connection structure (for example, a Cu stud) on the surface of the bridge die BG are exposed through grinding, to form the glass interposer 12.

A subsequent production process is basically the same as steps performed after the molding interposer 11 is completed in Embodiment 2. For details, refer to a corresponding part in Embodiment 2. Details are not described herein again.

The chip package structure in the foregoing embodiments is not limited to being made according to the production method provided in embodiments, and may alternatively be made according to another production method.

For example, in some possible implementations, in the chip package structure provided in Embodiment 1, Embodiment 2, or Embodiment 3, the plurality of substrates 30 may be first soldered on the hybrid interposer 10 and then molded, and then the chips D and the electronic elements 20 are assembled.

Production of the chip package structure in Embodiment 1 is used as an example, and a production method of the chip package structure may include the following steps.

First, the hybrid interposer 10a is made on the first carrier plate 01. For a specific production process, refer to FIG. 4A to FIG. 4C and the corresponding descriptions in Embodiment 1.

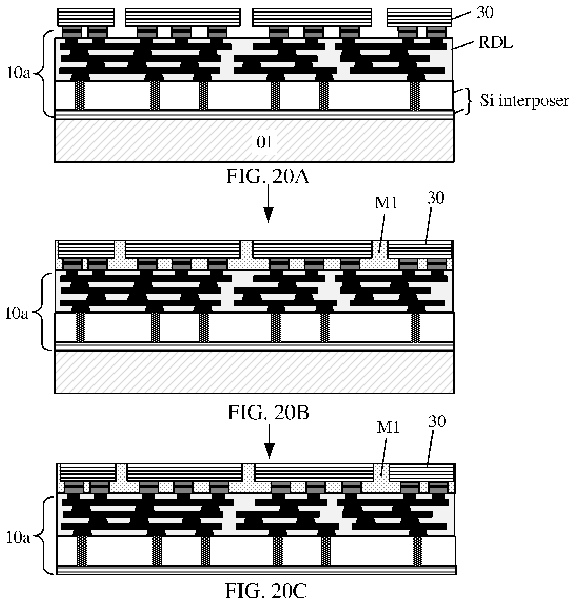

Next, as shown in FIG. 20A, the plurality of substrates 30 are soldered to pads on the surface of the redistribution layer RDL in the hybrid interposer 10a.

Next, as shown in FIG. 20B, the bottoms of the plurality of substrates 30 and the gap between the substrates 30 may be filled with the thermocurable material, and the back surface of the substrate 30 and the connection structure (for example, the Cu stud) are exposed through grinding, to form the molding layer M1 to protect the plurality of substrates 30.

Next, as shown in FIG. 20C, the first carrier plate 01 may be debonded and separated from the hybrid interposer 10a through laser burning, heat treatment, or the like, and the micro pad interface on the surface of the silicon interposer (Si interposer) is exposed.

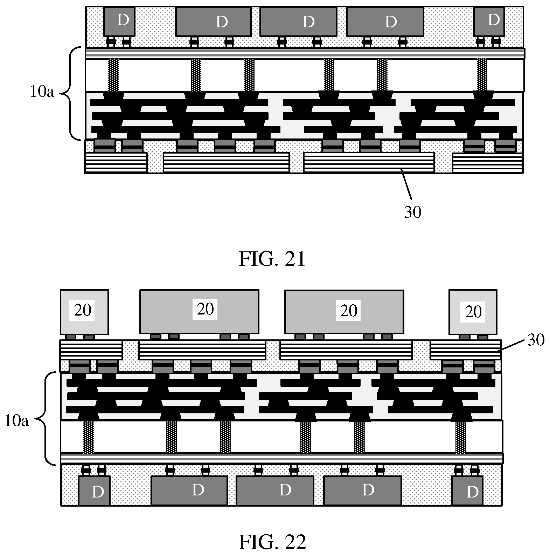

Next, as shown in FIG. 21, the plurality of heterogeneous chips D may be mounted on the surface of the first redistribution layer RDL1. Then, the bottoms of the plurality of chips and the gap between the chips may be filled with the thermocurable material, and then grinding (backside grinding) may be performed on the back surfaces of the plurality of chips D, to expose the back surfaces of the chips, so as to form the molding layer M2 to protect the plurality of chips D.

Next, as shown in FIG. 22, the plurality of electronic elements 20 (for example, functional modules such as a power assembly, a clock, and a passive component) may be separately soldered to the surfaces of the plurality of substrates 30, to implement vertical power supply interconnection between the electronic elements 20 and the substrates 30.

After this, a production process like opening processing, cutting, and mounting of the first heat dissipation panel 41, the second heat dissipation panel 42, the support frame 43, and the fastening structure 50 is performed on a non-routing region of the hybrid interposer 10b. For details, refer to the related descriptions in Embodiment 1. Details are not described herein again.

It should be understood that sequences in production processes in various embodiments of this application should be determined based on functions and internal logic of the production processes, and should not be construed as any limitation on the implementation process of embodiments of this application.

For other related content in the production methods in embodiments, refer to corresponding parts in the corresponding chip package structures. Details are not described herein again. For other disposing structures in the foregoing chip package structure embodiments, refer to the foregoing production methods and a related production method for adjustment. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip package structure, comprising:
a silicon interposer, wherein a front surface of the silicon interposer is provided with a metal routing layer, and a through silicon via TSV is disposed inside the silicon interposer;
a redistribution layer, formed on a back surface of the silicon interposer, and electrically connected to the through silicon via;
at least one first chip, located on the front surface of the silicon interposer, and electrically connected to the metal routing layer; and
at least one electronic element, located on a side that is of the redistribution layer and that is away from the first chip, and connected to the redistribution layer or connected to the redistribution layer through a substrate.

2. The chip package structure according to claim 1, wherein
the at least one first chip comprises one or more of a central processing unit, a graphics processing unit, a memory, an input/output chip, an integrated passive device, and a packaged functional assembly.

3. The chip package structure according to claim 1 or 2, wherein
the at least one electronic element comprises one or more of a power supply module, a control module, a connector, a clock device, a rectifier, and a resistor-capacitor-inductor.

4. The chip package structure according to any one of claims 1 to 3, wherein
the chip package structure comprises a plurality of first chips and a plurality of electronic elements.

5. The chip package structure according to claim 4, wherein
the plurality of electronic elements comprise a plurality of power supply modules, and the plurality of power supply modules are respectively disposed opposite to the plurality of first chips; and
through the redistribution layer and the silicon interposer, the power supply module is electrically connected to the oppositely disposed first chip, and supplies power to the first chip.

6. The chip package structure according to claim 4 or 5, wherein
the chip package structure comprises a plurality of substrates; and
the substrate is located between the redistribution layer and the electronic element, and the plurality of electronic elements are electrically connected to the redistribution layer through the plurality of substrates.

7. The chip package structure according to any one of claims 1 to 6, wherein
the chip package structure further comprises a first heat dissipation panel and a second heat dissipation panel; and
the first heat dissipation panel is disposed on a side that is of the first chip and that is away from the silicon interposer, and the second heat dissipation panel is disposed on a side that is of the plurality of electronic elements and that is away from the redistribution layer.

8. A chip package structure, comprising:
a first redistribution layer and a second redistribution layer;
at least one bridge die and a metal connection structure, connected between the first redistribution layer and the second redistribution layer, wherein the first redistribution layer is located on an active surface of the bridge die;
at least one first chip, located on a side that is of the first redistribution layer and that is away from the bridge die, wherein the first chip is electrically connected to the bridge die through the first redistribution layer; and
at least one electronic element, located on a side that is of the second redistribution layer and that is away from the first redistribution layer, and connected to the second redistribution layer or connected to the second redistribution layer through a substrate.

9. The chip package structure according to claim 8, wherein
a trace width, a trace spacing, and a trace thickness of a metal trace in the first redistribution layer are all less than 5 µm; and a trace width, a trace spacing, and a trace thickness of a metal trace in the second redistribution layer are all greater than 5 µm.

10. The chip package structure according to claim 8 or 9, wherein
the metal connection structure comprises a metal post; and
the bridge die and the metal post are molded in a molding layer.

11. The chip package structure according to claim 8 or 9, wherein
a glass wafer is disposed between the first redistribution layer and the second redistribution layer, and a trench is disposed in the glass wafer; and
the bridge die is embedded in the trench, and the metal connection structure comprises a through glass via TGV that penetrates the glass wafer.

12. The chip package structure according to any one of claims 8 to 11, wherein
the at least one first chip comprises one or more of a central processing unit, a graphics processing unit, a memory, an input/output chip, an integrated passive device, and a packaged functional assembly.

13. The chip package structure according to any one of claims 8 to 12, wherein
the at least one electronic element comprises one or more of a power supply module, a control module, a connector, a clock device, a rectifier, and a resistor-capacitor-inductor.

14. The chip package structure according to any one of claims 8 to 13, wherein
the chip package structure comprises a plurality of first chips and a plurality of electronic elements.

15. The chip package structure according to any one of claims 8 to 14, wherein
the chip package structure comprises a plurality of bridge dies; and
the bridge die is located at a position between two adjacent first chips, and the bridge die connects the two adjacent first chips through the first redistribution layer.

16. The chip package structure according to claim 14 or 15, wherein
the plurality of electronic elements comprise a plurality of power supply modules, and the plurality of power supply modules are respectively disposed opposite to the plurality of first chips; and
through the redistribution layer and the bridge die, the power supply module is electrically connected to the oppositely disposed first chip, and supplies power to the first chip.

17. The chip package structure according to any one of claims 14 to 16, wherein
the chip package structure comprises a plurality of substrates; and
the substrate is located between the redistribution layer and the electronic element, and the plurality of electronic elements are electrically connected to the second redistribution layer through the plurality of substrates.

18. The chip package structure according to any one of claims 8 to 17, wherein
the chip package structure further comprises a first heat dissipation panel and a second heat dissipation panel; and
the first heat dissipation panel is disposed on a side that is of the first chip and that is away from the first redistribution layer, and the second heat dissipation panel is disposed on a side that is of the electronic element and that is away from the second redistribution layer.

19. An electronic device, comprising a circuit board and the chip package structure according to any one of claims 1 to 18, wherein the chip package structure is electrically connected to the circuit board.
